# EUROPEAN PATENT APPLICATION

(11) **EP 4 312 251 A1**
(43) Date of publication of application: **31.01.2024**
(21) Application number: 23184401.0
(22) Date of filing: 10.07.2023
(51) Int. Cl.: H01L 21/67, G01N 21/956, G01N 21/95

(54) **MOUNTING APPARATUS AND METHOD FOR MANUFACTURING SEMICONDUCTOR DEVICE**

(30) Priority: 26.07.2022 JP 2022118333
(71) Applicant: Fasford Technology Co., Ltd., Yamanashi 400-0212 (JP)
(72) Inventor: KOBASHI, Hideharu, Yamanashi, 400-0212 (JP)
(74) Representative: Strehl Schübel-Hopf & Partner

(57) **Abstract**

A mounting apparatus includes: an imaging device (34); a lens (342) having chroma aberration; an illumination device (35); and a controller. When a subject (D) at a position different in working distance at a particular wavelength is imaged, the controller emits illumination lights having different wavelengths from the illumination device, and images the subject by the imaging device through the lens.

## Description

### Technical Field

The present disclosure relates to a mounting apparatus applicable to, for example, a die bonder that inspects a side surface of a die.

### Background Art

A mounting apparatus, such as a die bonder, is, for example, an apparatus that attaches (mounts) an element onto a substrate or an element by using a joining material. The joining material is, for example, a liquid-like or film-like resin, solder, or the like. The element is, for example, a die, such as a semiconductor chip, a MEMS (Micro Electro Mechanical System), or a glass chip. The substrate is, for example, a wiring substrate, a lead frame formed of a metal thin plate, a glass substrate, or the like.

For example, on the basis of an image obtained by using a camera, the die bonder performs the positioning of the element and the substrate, and performs the surface inspection of the element and the substrate.

### Citation List

### Patent Literature

PTL 1: Japanese Unexamined Patent Application Publication No. 2014-179558

### Summary of Invention

### Technical Problem

An object of the present disclosure is to provide a technique capable of increasing the accuracy of the positioning, the surface inspection, and the like of an element and a substrate. Other objects and novel features will be apparent from the description of the present specification and the accompanying drawings.

### Solution to Problem

Typical ones of the summary of this disclosure are briefly described as follows.

That is, a mounting apparatus comprises: an imaging device; a lens having chroma aberration; an illumination device; and a controller. When a subject at a position different in working distance (with different working distances) at a (each) particular wavelength is imaged, the controller emits illumination lights having different wavelengths from the illumination device, and images the subject by the imaging device through the lens. Advantageous Effects of Invention

According to the present disclosure, the accuracy of the positioning, the surface inspection, and the like of the element and the substrate can be increased.

### Brief Description of Drawings

Figure 1 is a schematic top view of a die bonder according to an embodiment;
Figure 2 is a schematic side view of the die bonder illustrated in Figure 1;
Figure 3 is a flowchart illustrating a method for manufacturing a semiconductor device by the die bonder illustrated in Figure 1;
Figure 4 is a schematic diagram illustrating a stage recognition camera, a coaxial illumination, and an intermediate stage;
Figure 5 is a schematic diagram illustrating the configuration of a surface emission illumination illustrated in Figure 4;
Figure 6 is a diagram illustrating the relationship between the wavelength and the variation in working distance;
Figure 7 is a diagram explaining the principle of the embodiment;
Figure 8 is a schematic diagram illustrating a substrate recognition camera, a coaxial illumination, and a bond stage onto which a substrate is placed;
Figure 9 is a schematic diagram illustrating the substrate recognition camera, the coaxial illumination, and the bond stage in which dies are stacked onto the substrate;
Figure 10 is a schematic diagram illustrating the configuration of a surface emission illumination illustrated in Figure 9; and
Figure 11 is a diagram illustrating the emission spectra of the surface emission illumination illustrated in Figure 10.

### Description of Embodiments

An embodiment and modification examples will be described below with reference to the drawings. It should be noted that in the following description, the same components are indicated by the same reference numerals, and the repeated description thereof may be omitted. It should be noted that to make the description more clearly, the drawings may be schematically represented for the widths, thicknesses, shapes, and the like of the respective portions as compared with the actual form. In addition, also between a plurality of mutual drawings, the dimension relationships between the respective elements, the ratios between the respective elements, and the like do not always coincide with each other.

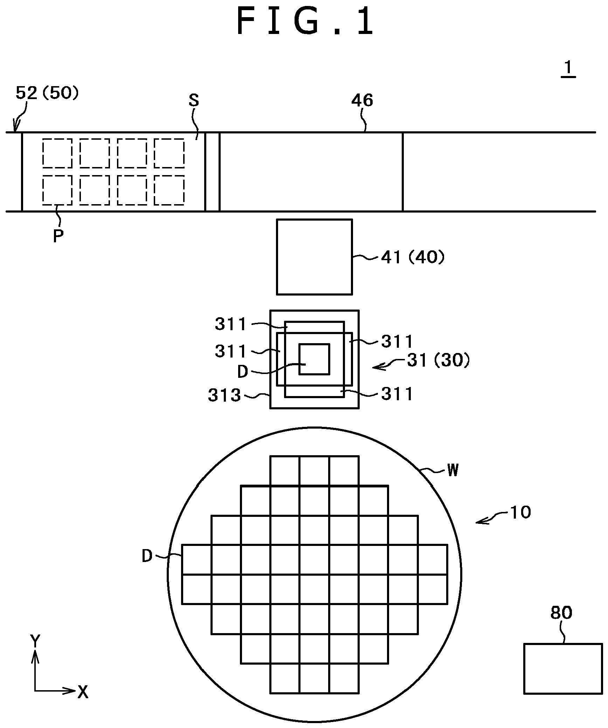

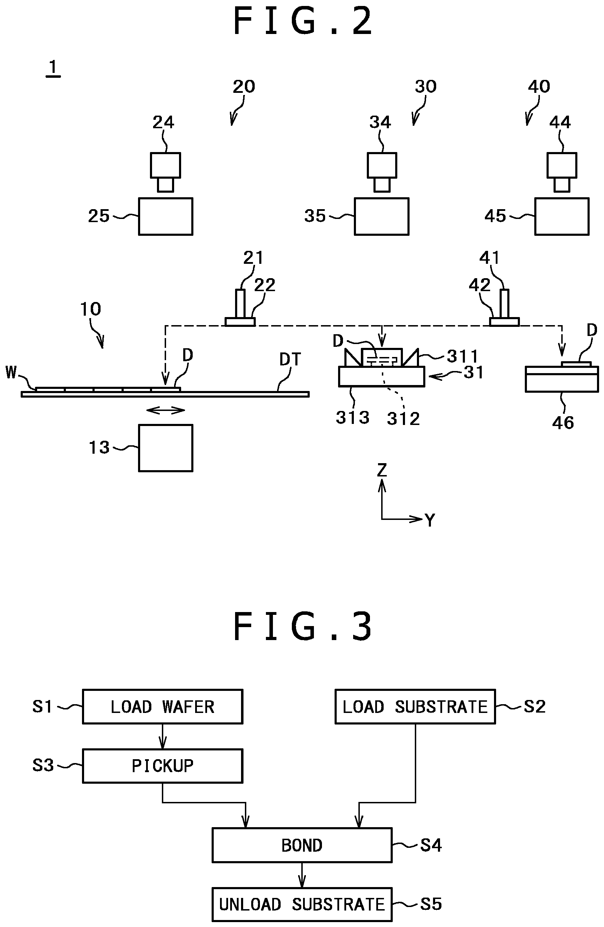

First, the configuration of a die bonder of the embodiment will be described with reference to Figures 1 and 2. Figure 1 is a schematic top view of the die bonder according to the embodiment. Figure 2 is a schematic side view of the die bonder illustrated in Figure 1.

A die bonder 1 mainly has a die supplying section 10, a pickup section 20, an intermediate stage section 30, a bonding section 40, a conveying section 50, and a controlling section (controller) 80 that monitors and controls the operation of each section. The Y axis direction is the front-rear direction of the die bonder 1, and the X axis direction is the left-right direction of the die bonder 1. The die supplying section 10 is disposed on the front side of the die bonder 1, and the bonding section 40 is disposed on the rear side of the die bonder 1.

The die supplying section 10 has a wafer holder (not illustrated) that holds a wafer W, and a separation unit 13 that separates a die D from the wafer W. The wafer holder is moved in the X-Y direction by a driving means, not illustrated, and the die D to be picked up is moved to the position of the separation unit 13. The separation unit 13 is moved in the up-down direction by a driving means, not illustrated. The wafer W is stuck onto a dicing tape DT, and is divided into a plurality of dies D. The dicing tape DT onto which the wafer W is stuck is held by a wafer ring, not illustrated. A film-like sticking material called a die attach film (DAF) is stuck to between the wafer W and the dicing tape DT. The die attach film is cured by being heated.

The pickup section 20 has a pickup head 21, a wafer recognition camera 24, and an illumination device 25. The pickup head 21 has a collet 22 that absorbingly holds the separated die D onto its end, picks up the die D from the die supplying section 10, and places it onto an intermediate stage 31. The wafer recognition camera 24 grasps the pickup position of the die D to be picked up from the wafer W. It should be noted that the pickup section 20 has an each driving section, not illustrated, that raises and lowers the pickup head 21, rotates it, and moves it in the X direction and the Y direction.

The intermediate stage section 30 has the intermediate stage 31, a stage recognition camera 34, and an illumination device 35. The intermediate stage 31 has a mirror 311, a seat 312, and a base 313. The stage recognition camera 34 is installed above the intermediate stage 31, and images the die D on the intermediate stage 31. The illumination device 35 is, for example, a coaxial illumination installed between the stage recognition camera 34 and the intermediate stage 31.

In addition, the mirror 311 has a reflection surface tilted at a predetermined angle with respect to the optical axis of the stage recognition camera 34, and four mirrors 311 are installed on the base 313. It should be noted that the number of mirrors 311 is not limited to four, and when only the particular side surfaces of the die D are recognized, may be the number corresponding to the number of the side surfaces. One mirror 311 opposite to one side surface of the die D may be configured of a plurality of mirrors.

For example, the mirror 311 is configured of a triangular prism in which opposite side surfaces have an isosceles right triangle shape, and the other side surface, a bottom surface, and a sloping surface having the reflection surface are rectangular. That is, the reflection surface is planar.

The predetermined angle is an angle in which the illumination light of the illumination device 35 is emitted at an angle close to the vertical direction with respect to the side surface of the die D and the side surface of the die D can be imaged at an angle close to the vertical direction. The predetermined angle is, for example, 45°±3°. More preferably, the predetermined angle is 45°±1°.

The die D is temporarily placed onto the seat 312. The placing surface of the seat 312 onto which the die D is placed is higher than the surface onto which the mirror 311 is placed (the upper surface of the base 313). In addition, the seat 312 has, for example, a columnar shape, and the size of the placing surface that is its upper surface is equal to or below the size of the die D. In this case, the seat 312 has a size in which the outer peripheral end portion of the die D is not distortedly deformed in a state where the die D is absorbed onto the placing surface. This enables the mirror 311 to be provided close to the die D. In addition, the imaging of the lower end portion of the die D becomes easy. In addition, it is also possible to respond to the case where the size of the die to be placed is changed. Thus, the seat 312 is preferably provided, but is not necessarily required to be provided.

For example, the stage recognition camera 34 is installed immediately above the intermediate stage 31, and is installed so as to direct the viewing angle downward in the vertical direction such that the center axis of the intermediate stage 31 and the optical axis of the stage recognition camera 34 coincide with each other. The stage recognition camera 34 is installed such that the die D and the reflection surfaces of the four mirrors 311 are positioned within a field of view. The illumination device 35 emits light in order to provide brightness such that the stage recognition camera 34 can image the die D placed onto the intermediate stage 31. The reflection light of the emitted light is incident onto the four mirrors 311. By this configuration, the stage recognition camera 34 can image the die D from its side surfaces to its upper surface.

The optical image incident onto the four mirrors 311 is incident along the optical axis of the stage recognition camera 34 installed above the four mirrors 311. The stage recognition camera 34 images a subject image reflected by each of the upper surface of the die D and the four mirrors 311. The image imaged by the stage recognition camera 34 can be outputted to the controlling section 80, be image processed, and be displayed also on a display screen (not illustrated).

The bonding section 40 has a bond head 41, a substrate recognition camera 44, and a bond stage 46. The bond head 41 has a collet 42 that absorbingly holds the die D at its end like the pickup head 21. The substrate recognition camera 44 images the position recognition mark (not illustrated) of a substrate S, and recognizes the bond position. Here, a plurality of product areas (hereinafter, referred to as package areas P) that finally become one package are formed on the substrate S. The position recognition mark is provided in each package area P. When the die D is placed onto the substrate S, the bond stage 46 is moved in the up direction, and supports the substrate S from below. The bond stage 46 has a suction port (not illustrated) for absorbing the substrate S by vacuum, and can fix the substrate S. The bond stage 46 has a heating section (not illustrated) that heats the substrate S. It should be noted that the bonding section 40 has an each driving section, not illustrated, that raises and lowers the bond head 41, rotates it, and moves it in the X direction and the Y direction.

By such the configuration, the bond head 41 corrects both or one of the pickup position and the posture on the basis of the imaging data of the stage recognition camera 34, and picks up the die D from the intermediate stage 31. Then, the bond head 41 bonds the die D onto the package area P of the substrate S on the basis of the imaging data of the substrate recognition camera 44, or bonds the die D by stacking the die D onto the die that has already been bonded onto the package area P of the substrate S.

The conveying section 50 has a conveying lane 52 on which the substrate S is moved. The conveying lane 52 conveys the substrate S in the X axis direction. By such the configuration, the substrate S is moved to the bond position (mounting position) from a substrate supplying section, not illustrated, along the conveying lane 52, and after the bond, is moved to a substrate unloading section, not illustrated, or is returned to the substrate supplying section.

The controlling section 80 includes: a memory that stores a program (software) that monitors and controls the operation of each of the above sections of the die bonder 1; and a central processing unit (CPU) that executes the program stored in the memory.

A bond process (manufacturing method) that is one process of the manufacturing process for a semiconductor device using the die bonder 1 will be described with reference to Figure 3. Figure 3 is a flowchart illustrating the method for manufacturing the semiconductor device by the die bonder illustrated in Figure 1. In the following description, the operation of each of the sections configuring the die bonder 1 is controlled by the controlling section 80.

### (A wafer loading step: step S1)

The wafer ring (not illustrated) is supplied to a wafer cassette (not illustrated) of the die bonder 1. The supplied wafer ring is supplied to the die supplying section 10, and is loaded into the die bonder 1. Here, the dicing tape DT onto which the dies D obtained by dividing the wafer W are stuck is held on the wafer ring.

### (A substrate loading step: step S2)

A substrate conveying jig in which the substrate S is stored is supplied to the substrate supplying section, and is loaded into the die bonder 1. The substrate S is taken out from the substrate conveying jig by the substrate supplying section, and is fixed to a conveying claw, not illustrated.

### (A pickup step: step S3)

After the step S1, the wafer holder is moved such that the desired die D can be picked up from the dicing tape DT. The die D is imaged by the wafer recognition camera 24, and the positioning and the surface inspection of the die D are performed on the basis of the image data obtained by the imaging.

The positioned die D is separated from the dicing tape DT by the separation unit 13 and the pickup head 21. The die D separated from the dicing tape DT is absorbed onto and held by the collet 22 provided on the pickup head 21, and is conveyed to and placed onto the intermediate stage 31.

The die D on the intermediate stage 31 is imaged by the stage recognition camera 34, and the positioning and the surface inspection of the die D are performed on the basis of the image data obtained by the imaging. The image data is image processed, so that the deviation amounts (the X, Y, θ directions) of the die D on the intermediate stage 31 from the die position reference point of the die bonder are calculated to perform the positioning. It should be noted that for the die position reference point, the predetermined position of the intermediate stage 31 is previously held as the initial setting of the apparatus. By image processing the image data, the surface inspection of the die D is performed.

The pickup head 21 that conveys the die D to the intermediate stage 31 is returned to the die supplying section 10. According to the above procedure, the next die D is separated from the dicing tape DT, and dies D are separated one by one from the dicing tape DT according to the same procedure hereafter.

### (A bond step: step S4)

The substrate S is conveyed to the bond stage 46 by the conveying section 50. The substrate S placed onto the bond stage 46 is imaged by the substrate recognition camera 44, and the image data is obtained by the imaging. The image data is image processed, so that the deviation amounts (the X, Y, θ directions) of the substrate S from the substrate position reference point of the die bonder 1 are calculated. It should be noted that for the substrate position reference point, the predetermined position of the bonding section 40 is previously held as the initial setting of the apparatus.

The absorption position of the bond head 41 is corrected from the deviation amounts of the die D on the intermediate stage 31 calculated in the step S3 to absorb the die D by the collet 42. The die D is bonded to the predetermined position of the substrate S supported by the bond stage 46 by the bond head 41 that absorbs the die D from the intermediate stage 31. Here, the predetermined position of the substrate S is the package area P of the substrate S, or the region when the element is additionally bonded onto the element that has already been placed, or the bond region of the element to be stacked and bonded. The die D bonded onto the substrate S is imaged by the substrate recognition camera 44, and the inspection of, for example, whether the die D has been bonded to the desired position is performed on the basis of the image data obtained by the imaging. When the inspected die D is defective, the die D is conveyed to the disposal region by the bond head 41.

The bond head 41 that bonds the die D onto the substrate S is returned to the intermediate stage 31. According to the above procedure, the next die D is piked up from the intermediate stage 31, and is bonded onto the substrate S. This is repeated to bond the dies D to all of the predetermined positions of the substrate S.

### (A substrate unloading step: step S5)

The substrate S onto which the die D is bonded is conveyed to the substrate unloading section. The substrate S is taken out from the substrate conveying claw by the substrate unloading section, and is stored in the substrate conveying jig. The substrate S stored in the substrate conveying jig is unloaded from the die bonder 1.

After the step S5, the substrate S onto which the die D is bonded is conveyed to a wire bonding step, and the electrode of the die D is electrically connected to the electrode of the substrate S through an Au wire or the like. For example, in the case of performing the stack bond, successively, the substrate S onto which the die D is bonded is loaded into the die bonder, thereby stacking the die D onto the die D bonded onto the substrate S, and after the substrate S is unloaded from the die bonder, the electrode of the die D is electrically connected to the electrode of the substrate S through the Au wire in the wire bonding step. The die D at the second stage or above is separated from the dicing tape DT by the above method, and is conveyed to the bonding section 40 to be stacked onto the die D. After the above step is repeated a predetermined number of times, the substrate S is conveyed to a mold step, and a plurality of dies D and the Au wire are sealed by a mold resin (not illustrated), thereby completing a stack package.

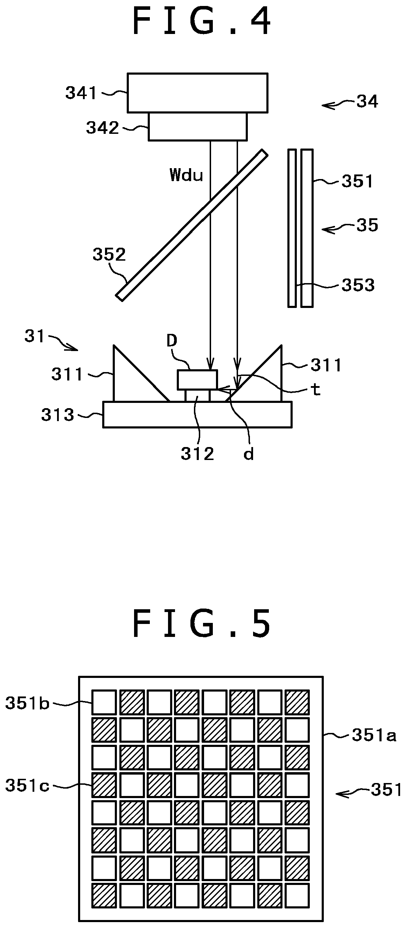

Next, the illumination device 35 will be described. Figure 4 is a schematic diagram illustrating the stage recognition camera, a coaxial illumination, and the intermediate stage according to the embodiment. Figure 5 is a schematic diagram illustrating the configuration of a surface emission illumination illustrated in Figure 4.

As illustrated in Figure 4, the illumination device 35 is disposed between the stage recognition camera 34 and the intermediate stage 31. The illumination device 35 includes a surface emission illumination (light source) 351, a semi-transparent mirror 352, and a diffusion plate 353. The stage recognition camera 34 includes an imaging device 341 and a lens 342. The illumination light from the surface emission illumination 351 is reflected in the same optical axis direction as the stage recognition camera 34 by the semi-transparent mirror 352, and is emitted onto an object to be imaged (subject) on the intermediate stage 31. The illumination light emitted onto the object to be imaged in the same optical axis direction as the stage recognition camera 34 is reflected onto the die D that is the object to be imaged, is transmitted through the semi-transparent mirror 352 to reach the stage recognition camera 34, and forms the image of the object to be imaged. The illumination device 35 is a coaxial episcopic illumination (coaxial illumination) device.

As illustrated in Figure 5, the surface emission illumination 351 includes a substrate 351a in which two types of LEDs 351b, 351c having different peak wavelengths are mounted at high density in checker pattern. For example, the LED 351b emits light having a longer wavelength than the LED 351c. Then, the LEDs 351b, 351c that perform light emission (lighting) are switched. This can divide the colors of the illuminations of the appearance inspection on the upper surface of the die D (upper surface inspection) and the positioning (alignment) on the upper surface of the die D and the appearance inspection on the side surface of the die D (side surface inspection).

The LED 351b that is the long wavelength illumination is used for the side surface inspection, and the LED 351c that is the short wavelength illumination is used for the upper surface inspection and the alignment. For example, red is used for the long wavelength illumination, and for example, blue is used for the short wavelength illumination. The lens 342 in which chroma aberration is not corrected is used. The lens 342 preferably has large chroma aberration.

By such the configuration, the stage recognition camera 34 images the die D twice by the illuminations having different wavelengths. That is, the image capturing is performed twice (This becomes double shot capturing.).

Next, to make the embodiment more clearly, the problems of the upper surface imaging and the side surface imaging will be described with reference to Figure 4.

The side surface inspection of the die D is performed by installing the mirror 311 tilted at an elevation angle of 45° on the intermediate stage 31. The imaging of the positioning on the upper surface and the upper surface inspection of the die D and the imaging of the side surface inspection of the die D are performed at the same time (by one exposure), so that the processing time can be shorter. For that, the focal points of the upper surface and the side surface of the die D are required to coincide with each other by one exposure.

However, as illustrated in Figure 4, seen from the lens 342, the subject distance (WDs) of the side surface of the die D is longer than the subject distance (WDu) of the upper surface of the die D by the addition distance (AD=t+d) obtained by adding the thickness (t) of the die D and the distance (d) from the side surface of the die D to the mirror 311. That is, WDs=WDu+AD. It should be noted that the addition distance (AD) is the same length at any position in the thickness direction on the side surface of the die D. The addition distance (AD) is required to be set to fall within the depth of field of the lens 342. Consequently, the upper limit or the like of the magnification is caused, and the sufficient magnification cannot be obtained.

In addition, it can also be considered that when the two-shot capturing is performed, an up-down moving mechanism is provided on the intermediate stage 31 or the stage recognition camera 34 and that a focus function is provided on the lens 342 to maintain the in-focus position. However, since these include the mechanical driving operation, when the position is changed once to be returned to the original position, the accuracy of the mechanical mechanism inevitably affects the reproducibility. Consequently, the deterioration of the bond accuracy is caused, and the moving time is long.

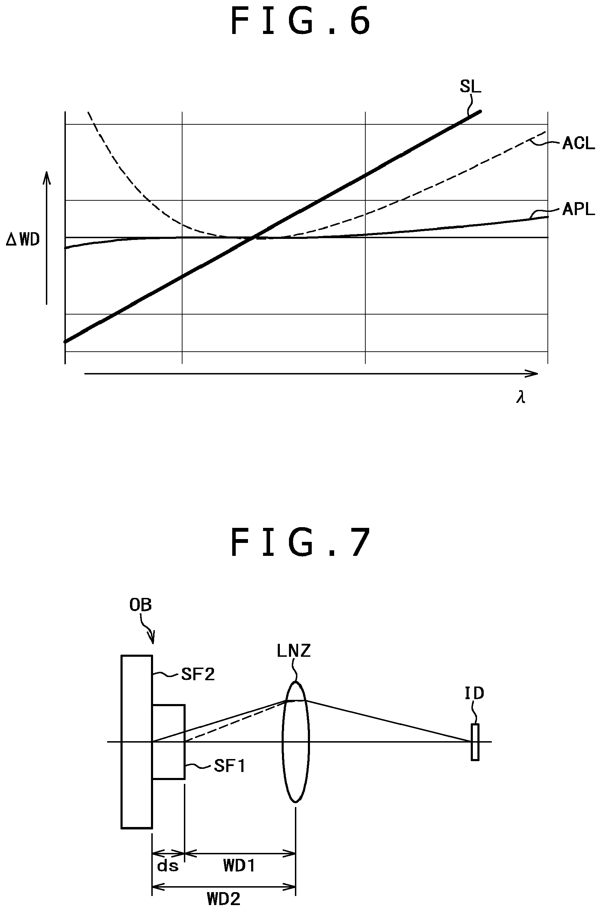

The reason why the present embodiment can solve the above problems will be described with reference to Figures 6 and 7. Figure 6 is a diagram illustrating the relationship between the wavelength and the variation in working distance. Figure 7 is a diagram explaining the principle of the present embodiment.

The lens has chroma aberration in which the focal point position is slightly deviated according to color.
That is, the distance (working distance: WD) from the end of the lens to the in-focus subject is varied according to the wavelength (λ) of the illumination.

As illustrated in Figure 6, since a single lens (SL) does not perform correction at all, the focal point position by wavelength is largely varied. That is, the variation in the WD (ΔWD) becomes large. Typically, to prevent these variations (correct chroma aberration), an achromat lens (ACL) and an apochromat lens (APL) in which a convex lens is combined with a concave lens or the like, and the like are used. These lenses that correct chroma aberration are required for the case where the wavelength region of the illumination cannot be limited, that is, for the optical system or the like at the white light source.

When the reflection spectrum of the object (subject) of the imaging is widened in wide band and the wavelength region used for the illumination is not required to be limited, the usage wavelength is not particularly required to be finely limited, for example, in the alignment, the inspection for confirming the presence or absence of the existence of damage or the like, and its determination function. Since the reflectivity does not become 0 in the visible region, the visualization is enabled at any wavelength. That is, the single lens and the lens, such as the achromat lens, having chroma aberration can be used.

In the present embodiment, the chroma aberration of the lens is used to cause the focal points of two surfaces SF1, SF2 of a subject OB different in the WD (for example, with a step) in the illumination lights having the predetermined wavelengths to coincide with each other with no mechanical operation. Here, the WD of the surface SF1 is WD1, and the WD of the surface SF2 is WD2. For example, as illustrated in Figure 7, when a lens LNZ, such as the single lens, is used to enhance chroma aberration, the surface SF1 of the subject OB closer to the lens LNZ emits the illumination of the short wavelength light (for example, blue) to obtain the image. The surface SF2 of the subject OB farther from the lens LNZ emits the illumination of the long wavelength light (for example, red) to obtain the image. The step (ds) is known, and the wavelength matching the step is selected such that both wavelength light illuminations are focused at the same position of an imaging device ID after being transmitted through the lens LNZ. This can obtain the image in which the focal points of the two surfaces different in the WD coincide with each other, simply by changing the color of the illumination.

The embodiment has one or a plurality of effects described below.
(1) The interval between the die D and the mirror 311 can be widened.
(2) By the above (1), the prism type mirror can be used as the mirror 311.
(3) By the above (1), the accidental collision between the reflection surface of the mirror 311 and the die D can be reduced.
(4) Since the stage recognition camera 34 and the intermediate stage 31 are not moved and a focal point adjecting mechanism is not used, the lowering of the positioning accuracy can be prevented.
(5) Since the stage recognition camera 34 and the intermediate stage 31 are not moved and the focal point adjecting mechanism is not used, the focal point switching can be performed at high speed.
(6) The lens having a high magnification can be used.
(7) The lens having a shallow depth of field can be used.
(8) By the above (7), the lens having a good resolution can be used.

### <Modification Examples>

Some representative modification examples of the embodiment will be illustrated below. In the description of the following modification examples, for portions having the same configurations and functions as those described in the above embodiment, the same reference numerals as the above embodiment can be used. Then, for the description of such the portions, the description according to the above embodiment can be incorporated, as needed, within the scope that is not technically inconsistent. In addition, part of the above embodiment and all or part of a plurality of modification examples are combinedly applicable, as needed, within the scope that is not technically inconsistent.

### (First Modification Example)

In the embodiment, the example in which the upper surface and the side surface of the die D are imaged on the intermediate stage 31 has been described. The present invention is also applicable to the case where the substrate S and the die D are imaged on the bond stage 46 (a first modification example).

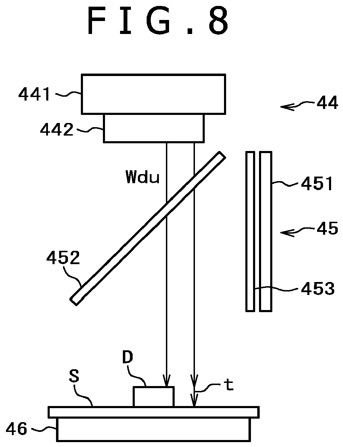

The first modification example will be described with reference to Figure 8. Figure 8 is a schematic diagram illustrating the substrate recognition camera, a coaxial illumination, and the bond stage onto which the substrate is placed.

In the first modification example, when whether the die D bonded onto the substate S has been bonded to the predetermined position is inspected, both of the substrate S and the die D are imaged. Thus, also in the first modification example, when the thickness of the die D exceeds the depth of field, there can be the same problem as the embodiment. Also in the first modification example, the problems can be solved like the embodiment.

Seen from a lens 442, the subject distance (WDd) of the die D is longer than the subject distance (Wdu) of the upper surface of the die D by the thickness (t) of the die D. That is, WDd=Wdu+t. The thickness (t) of the die D is required to be set to fall within the depth of field of the lens 442. Consequently, the upper limit or the like of the magnification is caused, and the sufficient magnification cannot be obtained.

In addition, it can also be considered that when the double shot capturing is performed, an up-down moving mechanism is provided on the bond stage 46 or the substrate recognition camera 44 and that a focus function is provided on the lens 442 to maintain the in-focus position. However, since these include the mechanical driving operation, when the position is changed once to be returned to the original position, the accuracy of the mechanical mechanism inevitably affects the reproducibility. Consequently, the deterioration of the bond accuracy is caused, and the moving time is long.

An imaging device 441 and the lens 442 of the substrate recognition camera 44 and an illumination device 45 according to the first modification example have the same configurations as the imaging device 341 and the lens 342 of the stage recognition camera 34 and the illumination device 35 according to the embodiment.

A surface emission illumination 451 is configured like the surface emission illumination 351 according to the embodiment. Then, the LEDs that perform light emission (lighting) at the time of the imaging of the substrate S and the imaging of the die D are switched. This can divide the colors of the illumination when the substrate S is imaged and the illumination when the die D is imaged.

The long wavelength illumination is used at the time of the imaging of the substrate S, and the short wavelength illumination is used at the time of the imaging of the die D. For example, red is used for the long wavelength illumination, and for example, blue is used for the short wavelength illumination.

By such the configuration, the positioning of the subjects different in height can be performed at high accuracy.

### (Second Modification Example)

In the first modification example, the example in which the substrate S and the thick die D are imaged on the bond stage 46 has been described. The present invention is also applicable to the case where the substrate S and the dies D stacked at multiple stages are imaged on the bond stage 46 (a second modification example).

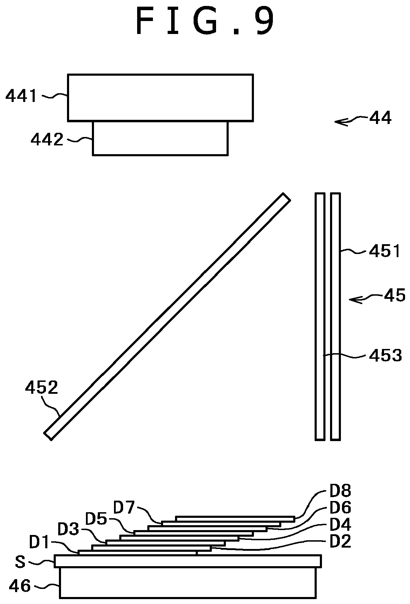

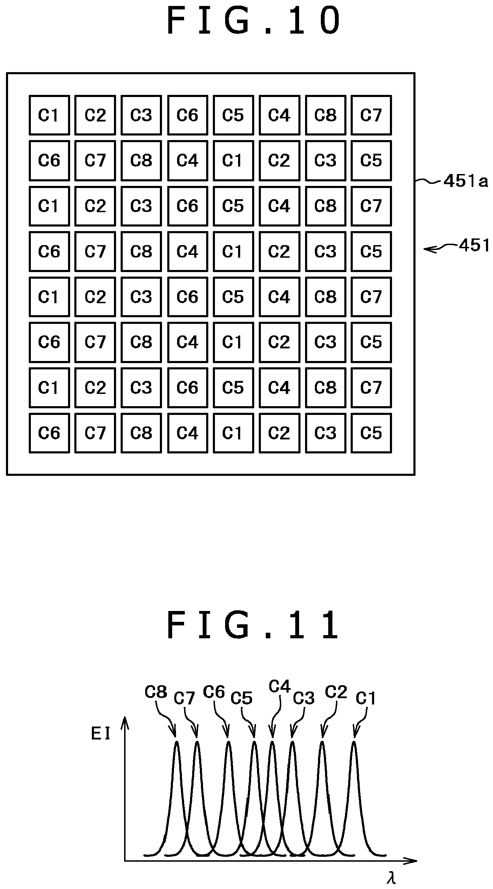

The second modification example will be described with reference to Figures 9 to 11. Figure 9 is a schematic diagram illustrating the substrate recognition camera, the coaxial illumination, and the bond stage onto which the substrate is placed. Figure 10 is a schematic diagram illustrating the configuration of the surface emission illumination illustrated in Figure 9. Figure 11 is a diagram illustrating the emission spectra of the surface emission illumination illustrated in Figure 10. The horizontal axis illustrated in Figure 11 is the wavelength (λ), and the vertical axis illustrated in Figure 11 is the emission intensity (EI).

Also in the second modification example, there can be the same problems as the embodiment. Also in the second modification example, the problems can be solved like the embodiment.

As illustrated in Figure 9, in the stacking structure in which the dies are bonded onto the bonded dies, the die height of the topmost layer using the substrate S as a reference is changed as the number of stacking stages is increased. It should be noted that dies D1 to D8 in the respective layers are positioned by using the substrate S as a reference. Consequently, there are the following problems.
(a) The fine foreign substance or the like comes out of focus and becomes blurred, and cannot be detected.
(b) Since the image of the die becomes an out-of-focus blurred image, the edge portion of the die cannot be detected at high accuracy, and the positioning accuracy of the die is deteriorated.
(c) In mounting a mechanical height adjusting mechanism and a focusing mechanism, when the position and the shape are changed once according to change and are then returned to the original position and shape, the position and the shape are affected by the reproducibility, so that the different result may be obtained even at the same position in the positioning process.

The substrate recognition camera 44 according to the second modification example has the same configuration as the substrate recognition camera 44 according to the first modification example. The illumination device 45 according to the second modification example includes the surface emission illumination 451, a semi-transparent mirror 452, and a diffusion plate 453.

As illustrated in Figure 10, the surface emission illumination 451 includes a substrate 451a in which eight types of LEDs (C1 to C8) having different emission intensity peak wavelengths are mounted at high density. Here, the LEDs (C1 to C8) have emission spectra as illustrated in Figure 11. Then, the LEDs that perform light emission (lighting) are switched at the respective wavelengths. This can select the wavelength of the illumination light used by the number of stacking stages. It should be noted that since the LEDs having the same wavelength are discretely disposed, the emission surface is preferably made uniform by the diffusion plate 453.

The illumination light of the LED (C1) having the longest wavelength is selected for the die D1 closest to the substrate S, the illumination light of the LED (C2) is selected for the die D2, the illumination light of the LED (C3) is selected for the die D3, the illumination light of the LED (C4) is selected for the die D4, the illumination light of the LED (C5) is selected for the die D5, the illumination light of the LED (C6) is selected for the die D6, the illumination light of the LED (C7) is selected for the die D7, and the illumination light of the LED (C8) having the shortest wavelength is selected for the die D8 farthest from the substrate S. This can obtain an in-focus image at any height of the stacked eight dies. In addition, it is possible to obtain the higher reproductivity than the system of the adjusting mechanism that mechanically changes the height to be inspected of the subject to return it to the original height.

### (Third Modification Example)

In the embodiment, the first modification example, and the second modification example, the example in which each of a plurality of types of illumination lights having different wavelengths is emitted for imaging and the imaging is performed a plurality of times by the number of the types of the illumination lights has been described. In a third modification example, the imaging is performed at the same time (by one exposure) by a multiple plate camera.

As illustrated in the embodiment, the first modification example, and the second modification example, even when a plurality of light source colors are prepared, the emission of the lights at the same time causes a synthetic image including an in-focus image and an out-of-focus image in using a single plate camera using one imaging element. Here, the imaging element is an image sensor of a CCD (Charge Coupled Device) or a CMOS (Complementary Metal Oxide Semiconductor).

Accordingly, in the third modification example, for the stage recognition camera 34 or the substrate recognition camera 44, for example, a two-plate camera using two imaging elements is used. Then, a filter that passes only blue is provided on one of light reception elements, and a filter that passes only red is provided on the other light reception element. Here, the filter that passes only blue may be a band pass filter, or may be a high pass filter. The filter that passes only red may be a band pass filter, or may be a low pass filter. Then, the illumination is made to have a mixed color of red and blue. Thus, since only each color is visible at each focal point, a plurality of images of the subject can be imaged by one exposure. That is, a plurality of WDs are provided with respect to the subject with the step or the like that largely exceeds the depth of field, thereby enabling the imaging by one exposure.

Specifically, in the configuration according to the embodiment, the side surface images of the die D can be reflected onto the reflection surfaces of the mirrors 311, and the upper surface and four side surfaces of the die D can be imaged and inspected at the same time (within the same exposure) by the stage recognition camera 34 installed above the intermediate stage 31.

In addition, when a three-plate camera using three imaging elements is used, up to the third stage can be imaged by one exposure in the multi-stage stacking of the second modification example. In this case, the light source light should not be the white light having the wide band emission spectrum, and is desirably the mixed light of a plurality of light sources each having a peak at each designated wavelength.

The disclosure made by the present disclosers has been specifically described above on the basis of the embodiment and the modification examples, but the present disclosure is not limited to the embodiment and the modification examples described above, and needless to say, various modifications can be made.

For example, in the assembling apparatus including the die bonder, various elements, such as the semiconductor chip, the MEMS, and the wafer, are mounted on the substrate or the like, so that the positioning of the XY on the planar surface is important, but the positioning and the inspection function in a plurality of layers having the step (the difference of the WD) influenced by the three-dimensional shape in that process are required. The present disclosure is applicable also to these.

In the second modification example, the example in which the stepwise wavelength switching is performed by switching the lightings of the LEDs having different peak wavelengths has been described, but a plurality of band pass filters having different passing wavelengths may be prepared to switch the band pass filters disposed on the front surface of the emission surface of the white light.

In the third modification example, the example in which the multiple plate camera is used to perform the imaging by one exposure has been described, but the single plate camera including one imaging element in which the color filters disposed in two dimensions are stuck together onto the light reception surface may be used to separate the colors of red (R), green (G), and blue (B), thereby reproducing the image.

In the embodiment, the die bonder in which the die is picked up by the pickup head from the die supplying section to place it onto the intermediate stage, and the die placed onto the intermediate stage is picked up by the bonding head to bond it onto the substrate has been described, but without the pickup head, the die in the die supplying section may be picked up by the bonding head to place it onto the intermediate stage, and the die placed onto the intermediate stage may be picked up by the bonding head to bond it onto the substrate.

In the embodiment, the DAF is stuck onto the back surface of the wafer, but the DAF is not necessarily required.

In the embodiment, the die is bonded with its front surface face up, but the die may be bonded with its back surface face up by reversing the front and back of the die after the die is picked up. This apparatus is called a flip chip bonder.

In the embodiment, the example in which the die is picked up from the wafer in the die supplying section has been described, but the die may be picked up from a tray.

In the embodiment, the present invention has been described by taking the die bonder as an example, but is also applicable to a chip mounter (surface mounting machine) in which an electronic component and a semiconductor chip are disposed on a wiring substrate.

### Reference Signs List

- 1: die bonder (mounting apparatus),
- 80: controlling section (controller),
- 341, 441: imaging device,
- 342, 442: lens,
- 35, 45: illumination device

## Claims

1. A mounting apparatus comprising:
an imaging device;
a lens having chroma aberration;
an illumination device; and
a controller,
wherein when a subject at a position different in working distance at a particular wavelength is imaged, the controller emits illumination lights having different wavelengths from the illumination device, and images the subject by the imaging device through the lens.

2. The mounting apparatus according to claim 1,
wherein the illumination device is a coaxial illumination having a surface emission illumination and a semi-transparent mirror, and
wherein the surface emission illumination can output one or a plurality of illumination lights having different wavelengths.

3. The mounting apparatus according to claim 2,
wherein the controller emits the illumination light having a first wavelength from the illumination device to image the subject by the imaging device, and emits the illumination light having a second wavelength different from the first wavelength from the illumination device to image the subject by the imaging device.

4. The mounting apparatus according to claim 2 or 3,
wherein the imaging device is a two-plate camera, and
wherein the controller emits the illumination light having the first wavelength and the illumination light having the second wavelength different from the first wavelength from the illumination device, to image the subject by the imaging device.

5. The mounting apparatus according to claim 2 or 3,
wherein the imaging device is a three-plate camera, and
wherein the controller emits the illumination light having the first wavelength, the illumination light having the second wavelength different from the first wavelength, and the illumination light having a third wavelength being short and different from the second wavelength from the illumination device, to image the subject by the imaging device.

6. The mounting apparatus according to claim 3 or 4,
wherein the second wavelength is shorter than the first wavelength.

7. The mounting apparatus according to claim 5,
wherein the second wavelength is shorter than the first wavelength, and
wherein the third wavelength is shorter than the second wavelength.

8. The mounting apparatus according to claim 3 or 4 or 6, further including:
an intermediate stage in which a mirror is installed onto the upper surface thereof,
wherein the imaging device is provided above the intermediate stage such that a die placed onto the intermediate stage and the reflection surface of the mirror are positioned within a field of view,
wherein the illumination device is provided below the imaging device and above the intermediate stage, and
wherein the subject is the upper surface and the side surface of the die placed onto the intermediate stage.

9. The mounting apparatus according to claim 3 or 4 or 6,
wherein a bond stage is further provided,
wherein the imaging device is provided above the bond stage such that a substrate placed onto the bond stage and the die bonded onto the substrate are positioned within a field of view,
wherein the illumination device is provided below the imaging device and above the bond stage, and
wherein the subject is the die and the substrate.

10. The mounting apparatus according to claim 3 or 5 or 7,
wherein the bond stage is further provided,
wherein the imaging device is provided above the bond stage such that the substrate placed onto the bond stage and the die bonded onto the substrate are positioned within a field of view,
wherein the illumination device is provided below the imaging device and above the bond stage, and
wherein the subject is the substrate and the die bonded onto the substrate.

11. A method for a semiconductor device comprising the steps of:
loading a wafer that is stuck onto a dicing tape, into a die bonding apparatus that includes an imaging device, a lens having chroma aberration, an illumination device, and a controller in which when a subject at a position different in working distance at a particular wavelength is imaged, the controller emits illumination lights having different wavelengths from the illumination device, and images the subject by the imaging device through the lens;
picking up a die from the wafer to place the die onto a stage; and
picking up the die from the stage to place the die onto a substrate.

12. The method according to claim 11,
wherein a step of inspecting the side surface of the die placed onto the stage is further included.
